# EUROPEAN PATENT APPLICATION

(11) **EP 4 790 860 A1**
(43) Date of publication of application: **12.08.2026**
(21) Application number: 26152550.5
(22) Date of filing: 19.01.2026
(51) Int. Cl.: H02H 3/16, H02H 7/26

(54) **SYSTEMS AND METHOD FOR FAULT PROTECTION**

(30) Priority: 11.02.2025 US 202519050123
(71) Applicant: GE Aviation Systems Limited, Cheltenham Gloucestershire GL52 8SF (GB)
(72) Inventor: ELDER, James Angelo, Cheltenham, GL52 8SF (GB); PANCHOLI, Kieran Sandeep, Cheltenham, GL52 8SF (GB); FAZELI, Seyed, Cheltenham, GL52 8SF (GB)
(74) Representative: Openshaw & Co.

(57) **Abstract**

A system and method for fault protection are described herein. An electrical power system architecture (100) for an aircraft includes at least one electrical source (102), at least one electrical load (112), and a power distribution system (106) connecting the at least one electrical source (102) to the at least one electrical load (112). The power distribution system (106) is grounded to an electrical ground (118) of the aircraft through a high impedance grounding circuit (108) and a plurality of protection devices (124) are coupled electrically upstream and downstream of the high impedance grounding circuit (108). In some approaches, the electrical power system architecture (100) includes a fault detection circuit (126) configured to detect a fault and a controller (128) to selectively open or close the plurality of protection devices (124) based on the detected fault. In some approaches, an electrical wiring interconnection system separates positive power 1(114) and negative power lines (116) of the power distribution system (106) for reducing line-to-line faults.

## Description

### TECHNICAL FIELD

These teachings relate generally to electrical power distribution systems and more particularly to fault protection in power distribution systems.

### BACKGROUND

Aircraft electrical power systems are used to support various onboard functions and operations of the aircraft. These aircraft electrical power systems often include a distribution system to distribute electrical power from an electrical source and an electrical load. Modern electrical systems may operate at higher voltages and currents, which can elevate the risk of a fault and amplify the impact of such faults. Accordingly, an architecture designed to increase the fault tolerance of an aircraft electrical power system may be desirable.

### BRIEF DESCRIPTION OF DRAWINGS

Various needs are at least partially met through provision of the system and method for fault protection described in the following detailed description, particularly when studied in conjunction with the drawings. A full and enabling disclosure of the aspects of the present description, including the best mode thereof, directed to one of ordinary skill in the art, is set forth in the specification, which refers to the appended figures, in which:
FIG. 1 depicts an electrical system architecture in accordance with various embodiments of these teachings;
FIG. 2 depicts a power distribution system in accordance with various embodiments of these teachings;
FIG. 3 depicts a circuit diagram of a high impedance grounding path in accordance with various embodiments of these teachings;
FIGS. 4A-4B depict an electrical system architecture in accordance with various embodiments of these teachings;
FIGS. 5A-5D depict an electrical system architecture in accordance with various embodiments of these teachings;
FIG. 6 depicts a flowchart of a method for detecting a ground fault in accordance with various embodiments of these teachings; and
FIG. 7 depicts a flowchart of a method for responding to faults in an electrical power distribution network of an aircraft in accordance with various embodiments of these teachings.

Elements in the figures are illustrated for simplicity and clarity and have not necessarily been drawn to scale. For example, the dimensions and/or relative positioning of some of the elements in the figures may be exaggerated relative to other elements to help to improve understanding of various embodiments of the present teachings. Also, common but well-understood elements that are useful or necessary in a commercially feasible embodiment are often not depicted in order to facilitate a less obstructed view of these various embodiments of the present teachings. Certain actions and/or steps may be described or depicted in a particular order of occurrence while those skilled in the art will understand that such specificity with respect to sequence is not actually required.

### DETAILED DESCRIPTION

The approaches provided herein provide an architecture and protection strategy to protect the power distribution system deployed in an electrical power system of an aircraft. In these regards and as will be described herein, the combination of a high impedance grounding scheme, an electrical wiring interconnection system (EWIS) strategy and a control system is used to prevent, detect and isolate a fault during a short circuit event.

Traditionally, aircraft power systems are grounded using a TN-C-S (4-wire) system, with the low side of the electrical source and the electrical load grounded to the aircraft chassis. For high-voltage, high-current aircraft applications, a TN-C-S (4-wire) system may not be applicable due to the high currents and fault energies produced during faults. Additionally, TN-C-S systems which ground to the fuselage may not work for carbon-fiber-reinforced polymer (CFRP) skins, as high CFRP electrical resistance may prevent the faults from being detected and the fault current flowing through the CFRP may cause heating and degradation of the CFRP.

Advantageously, the approaches described herein provide an architecture and protection strategy designed for high-voltage, high-current aircraft applications, including CFRP aircraft. The high impedance grounding scheme reduces fault currents in the event of a line-to-ground fault, such that any line-to-ground fault is a low energy fault. As such, the high impedance grounding scheme allows an airframer to reduce separation distances between the aircraft electrical system and other components (e.g., fuel lines) as no fault will occur on contact. Moreover, the electrical wiring interconnection system (EWIS) as described herein, separates the positive and negative power line to mitigate the existence and zones in which line-to-line faults can occur. Therefore, the need for armoring throughout the aircraft may be reduced, leading to weight saving and cost reduction.

In many of these embodiments, the electrical power system architecture includes at least one electrical source, at least one electrical load, and a power distribution system. The power distribution system connects the at least one electrical source to the at least one electrical load and includes positive power lines and negative power lines . The electrical power system architecture also includes a high impedance grounding path connected between the power distribution system and an electrical ground of the aircraft. The electrical power system architecture further includes a plurality of protection devices coupled to the power distribution system and a fault detection circuit configured to detect a fault. A controller is communicatively coupled to the high impedance grounding circuit, the plurality of protection devices, and the fault detection circuit and configured to selectively open or close the first subset and/or the second subset of the plurality of protection devices based on the detected fault. In aspects, the plurality of protection devices include a first subset of the plurality of protection devices coupled electrically upstream of the high impedance grounding circuit and a second subset of the plurality of protection devices coupled electrically downstream of the high impedance grounding circuit.

The terms and expressions used herein have the ordinary technical meaning as is accorded to such terms and expressions by persons skilled in the technical field as set forth above except where different specific meanings have otherwise been set forth herein. The word "or" when used herein shall be interpreted as having a disjunctive construction rather than a conjunctive construction unless otherwise specifically indicated. The terms "coupled," "fixed," "attached to," and the like refer to both direct coupling, fixing, or attaching, as well as indirect coupling, fixing, or attaching through one or more intermediate components or features, unless otherwise specified herein.

The terms "upstream" and "downstream" refer to the relative direction with respect to the flow of electrical current. For example, "upstream" refers to the direction from which the electrical current originates, and "downstream" refers to the direction to which the electrical current is received.

The singular forms "a", "an", and "the" include plural references unless the context clearly dictates otherwise.

Approximating language, as used herein throughout the specification and claims, is applied to modify any quantitative representation that could permissibly vary without resulting in a change in the basic function to which it is related. Accordingly, a value modified by a term or terms such as "about", "approximately", and "substantially", are not to be limited to the precise value specified. In at least some instances, the approximating language may correspond to the precision of an instrument for measuring the value, or the precision of the methods or machines for constructing or manufacturing the components and/or systems. For example, the approximating language may refer to being within a 10 percent margin.

The foregoing and other benefits may become clearer upon making a thorough review and study of the following detailed description.

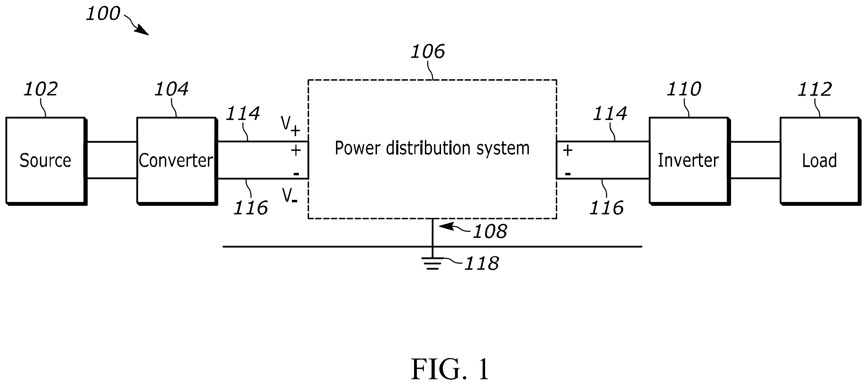

Referring now to the drawings, FIG. 1 is electrical power system architecture 100 for an aircraft. The aircraft may be configured as an electric or hybrid electric aircraft. The electrical power system architecture 100 includes an electrical source 102, a conversion unit 104, a power distribution system 106, a high impedance grounding circuit 108, an inversion unit 110, and an electrical load 112.

The electrical source 102 may be any power source of the aircraft that supplies electrical power. In examples, the electrical source 102 may be at least one of a battery, a fuel cell, or a generator. It will be appreciated that although the embodiment of FIG. 1 depicts a single electrical source, in other exemplary embodiments, the electrical power system architecture 100 may include any suitable number of electrical sources (e.g., 2, 3, 4, etc.). The electrical sources may be of the same type or combinations of different types of electrical sources.

The conversion unit 104 is in series connection with the electrical source 102. The conversion unit 104 is configured to match the voltage and power levels between the electrical source 102 and the power distribution system 106. In particular, the conversion unit 104 may include one or more converters to convert the received electrical power from, e.g., an alternating current (AC) or a direct-current (DC) electrical power.

The inversion unit 110 is in series connection with the electrical load 112. The inversion unit 110 is configured to adjust the voltage and power levels between the power distribution system 106 and the electrical load 112. In particular, the inversion unit 110 may include one or more inverters to convert the received electrical power from, e.g., a DC electrical power to an AC electrical power.

The electrical load 112 may be any system or component in an aircraft that is supplied an electrical power from the electrical source 102. The electrical load 112 may be a passive electrical load or an active electrical load. In examples, the electrical load may be a pump, a heating element, an electrical distribution equipment or an electric machine. In one example, the electric machine is configured as an electric motor in a propulsion system configured to receive the electric power and convert the electric power into a mechanical, rotational force to drive a fan and generate thrust. It will be appreciated that although the embodiment of FIG. 1 depicts a single electrical load, in other exemplary embodiments, the electrical power system architecture 100 may include any suitable number of electrical loads (e.g., 2, 3, 4, etc.). The electrical loads may be of the same type or combinations of different types of electrical loads.

The power distribution system 106 is operatively coupled between the electrical source 102 and the electrical load 112. In particular, the electrical source 102 and conversion unit 104 are operatively coupled to the inversion unit 110 and the electrical load 112 via the power distribution system 106. The electrical power provided by the electrical source 102 is converted by the conversion unit 104 and provided to the power distribution system 106. Further, the electrical power provided by the power distribution system 106 is converted by the inversion unit 110 and provided to the electrical load 112.

The power distribution system 106 includes positive power line 114 (i.e., a positive pole) and negative power line 116 (i.e., a negative pole) coupling the electrical source 102 to the electrical load 112. The positive power line 114 and negative power line 116 are each at an electric potential with respect to electrical ground 118, designated V₊ and V₋, respectfully. As used herein, "power line" refers to any suitable mechanism or component used to conduct electrical current, including but not limited to, conductive cables, power rails, or other conductive pathways.

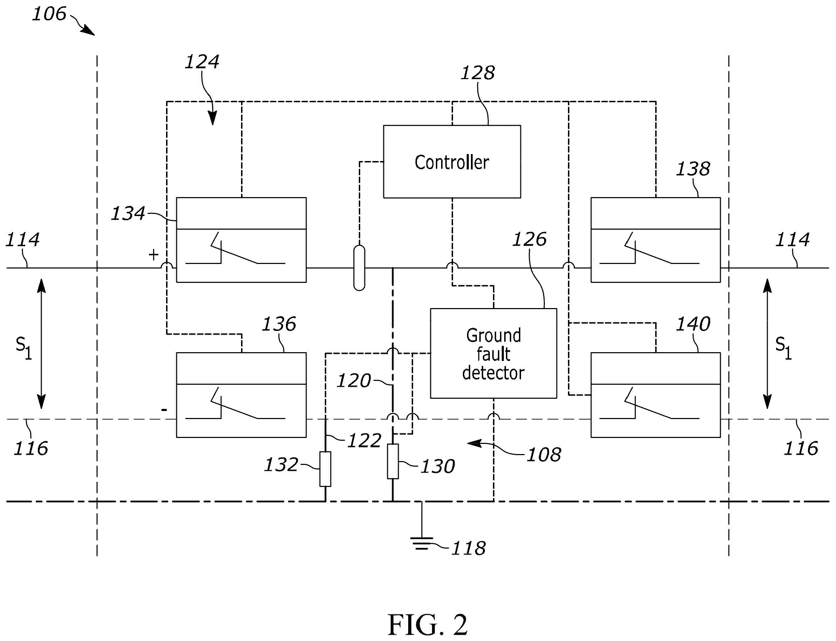

The electrical power system architecture 100 is grounded through a high impedance grounding circuit 108. Specifically, the power distribution system 106 is grounded to an electrical ground 118 of an aircraft through the high impedance grounding circuit 108. In other words, the positive power lines 114 and the negative power lines 116 are connected to the electrical ground 118 of the aircraft via the high impedance grounding circuit 108. The high impedance grounding circuit 108, as will be more fully described below, is provided with high impedance components as shown in FIG. 2 such that any line-to-ground (L-G) fault is a low energy fault. Advantageously, the separation distance between the electrical power system architecture 100 and other aircraft systems (e.g., fuel lines) may be reduced as no fault will occur on contact. It should be understood that the electrical power system architecture 100 is shown at a schematic level and may include other aspects and components that are not necessary for an understanding of this subject matter.

Referring to FIG. 2, a schematic view of the power distribution system 106 of FIG. 1 shown. The power distribution system 106 further includes a first high impedance grounding path 120, a second high impedance grounding path 122, a plurality of protection devices 124, a fault detection circuit 126, and a controller 128.

As described above, the power distribution system 106 is grounded to the electrical ground 118 of an aircraft through the high impedance grounding circuit 108. The high impedance grounding circuit 108 includes a first high impedance grounding path 120 connected between the positive power line 114 and the electrical ground 118 and a second high impedance grounding path 122 connected between the negative power line 116 and the electrical ground 118. The first high impedance grounding path 120 is in electrical parallel connection with the second high impedance grounding path 122.

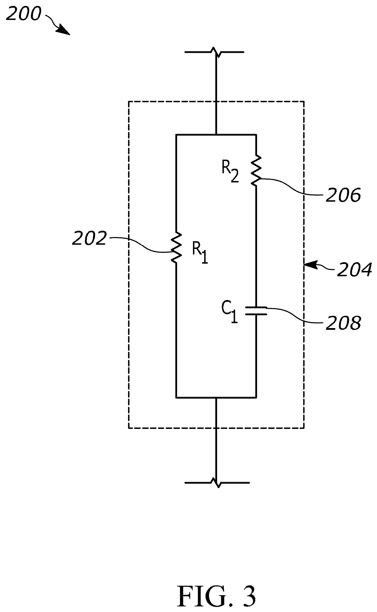

The first high impedance grounding path 120 includes a first high impedance component 130 and the second high impedance grounding path 122 includes a second high impedance component 132. The high impedance components may be selected to mitigate the transient voltage and current disturbances caused by failures. In examples, one of the first high impedance component 130 or the second high impedance component 132 may include a first resistor (R1), and the other one of the first high impedance component 130 or the second high impedance component 132 may include a damper circuit 204 as shown in FIG. 3. The damper circuit may include a resistor (R2) in electrical series with a capacitor (C1). A resistance value of the first resistor (R1) may be selected based on a rated current capacity of the resistor (R1). A resistance value of the second resistor (R2) and a capacitance value of the capacitor (C1) may be selected based on a speed for damping transients in the event of a fault. In other examples, the first high impedance component 130 and the second high impedance component 132 may both include a resistor.

The plurality of protection devices 124 includes protection devices 134-140 operatively coupled to the positive power line 114 and the negative power line 116. The plurality of protection devices 124 includes a first subset of protection devices upstream the high impedance grounding circuit 108 and a second subset of protection devices downstream the high impedance grounding circuit 108. In particular, the first subset of protection devices includes a first protection device 134 operatively coupled to the positive power line 114 upstream the first high impedance grounding path 120 and a second protection device 136 operatively coupled to the negative power line 116 upstream the second high impedance grounding path 122. The second subset of protection devices includes a third protection device 138 operatively coupled to the positive power line 114 downstream the first high impedance grounding path 120 and a fourth protection device 140 operatively coupled to the negative power line 116 downstream the second high impedance grounding path 122. The protection devices 134-140 detect abnormal conditions, interrupt and/or isolate overcurrent, short circuit and fault events in the power distribution system 106 and may include electro-mechanical circuit breakers, contactors, relays, solid-state power controllers (SSPC), or the like. More specifically, in an exemplary embodiment, the first protection device 134 and the second protection device 136 may be a fast-acting protection device (e.g., a SSPC). The second protection device 136 and the fourth protection device 140 may be a fast-acting protection device (e.g., a SSPC) or a slow-acting protection device (e.g., a contactor). It is generally contemplated that any of various types of electrical or electronic or other types of protection devices may be used. It will be appreciated that although FIG. 2 discloses four protection devices, the power distribution system may include any suitable number of protection devices (e.g., 6, 8, 10, 12, etc.).

A fault detection circuit 126 is used to detect a fault in the power distribution system 106. The fault detection circuit 126 is operatively connected to the high impedance grounding circuit 108 and the electrical ground 118. The fault detection circuit 126 may include a voltage sensor or an impedance monitor for providing line-to-ground fault detection.

The power distribution system 106 further includes a current sensor. The current sensor may be any type of current sensing device and may include separate current sensing monitors or sensors that may be provided for any of the protection devices 134-140 in order to detect an overcurrent condition and determine an overcurrent direction for providing line-to-line fault detection. In examples, the current sensing devices may be integrated in the controller 128.

The controller 128 can be any microcontroller, computer, or processor-based device with processor, memory, and programmable input/output peripherals, which is generally designed to govern the operation of other components and devices. It is further understood to include common accompanying accessory devices, including memory, transceivers for communication with other components and devices, etc. These architectural options are known and understood in the art. The controller 128 may be configured (for example, by using corresponding programming stored in a memory as will be well understood by those skilled in the art) to carry out one or more of the steps, actions, and/or functions described herein (e.g. predetermined commands). The controller 128 may include a memory that includes computer instructions (e.g., predetermined commands) that implement any of the functions described herein.

The controller 128 is configured to obtain voltage or impedance readings from the fault detection circuit 126 and current readings from the current sensor and utilize one or more of these readings to determine when to actuate one or more of the plurality of protection devices 124. The controller 128 may actuate one or more of the plurality of protection devices 124 based on a fault state including a line-to-line fault or a line-to-ground fault. In one example, the controller may be configured to send a trip signal to selectively actuate the first subset of the plurality of protection devices 134, 136 or a second subset of the plurality of protection devices 138, 134 when a change in the grounding impedances of the first or second high impedance grounding path 120, 122 as measured by the impedance monitor or a variation of voltages between the positive pole (i.e., the positive power line 114) to electrical ground 118 and the negative pole (i.e., the negative power line 116) to electrical ground 118 as measured by the voltage detector exceeds given values. In another example, the controller may be configured to send a trip signal to selectively actuate the first subset of the plurality of protection devices 134, 136 or a second subset of the plurality of protection devices 138, 134 when a current as measured by the current sensor exceeds given values.

In some embodiments, the power distribution system 106 includes a power distribution box that houses (encloses) the electrical and/or electronic components including the high impedance grounding circuit 108, the plurality of protection devices 124, the fault detection circuit 126 and the controller 128. The power distribution box includes a power input coupled to the electrical source 102 and a power output coupled to the electrical load 112. The power distribution box may also be coupled, and distribute electrical power, to multiple systems. In other words, the power distribution box may be operatively coupled to one or more electrical sources and one or more electrical loads.

In some embodiments, the power distribution system 106 further includes an electrical wiring interconnection system (EWIS) configured to separate the positive power lines 114 and the negative power lines 116 for line-to-line fault protection, represented by arrows S₁. The positive power lines 114 and the negative power lines 116 are arranged and routed through the power distribution system 106 such that they are separated. In examples, the positive power lines 114 and negative power lines 116 positioned along the aircraft structure (e.g., fuselage, wings, etc) are physically separated through the EWIS. In some examples, the EWIS may be integrated in the power distribution box such that the positive power lines 114 and the negative power lines 116 in the power distribution box are separated.

Referring now to FIG. 3, a high impedance grounding path 200 in accordance with some embodiments is provided. The exemplary high impedance grounding path 200 may be incorporated into the exemplary high impedance grounding circuit 108, and in particular, the first and second high impedance grounding path 120, 122 as depicted in FIG. 2. The high impedance grounding path 200 includes two parallel branches with a first resistor 202, in parallel electrical connection a damper circuit 204. The damper circuit 204 includes a second resistor 206 in series electrical connection with a capacitor 308. A resistance value of the first resistor 202 may be selected based on a rated current capacity of the resistor (R1). A resistance value of the second resistor 206 and a capacitance value of the capacitor 208 may be selected based on a speed for damping transients in the event of a fault. In this manner, the high impedance grounding path 200 reduces a line-to-ground fault energy, such that in the event of a fault, any line-to-ground fault is a lower energy fault.

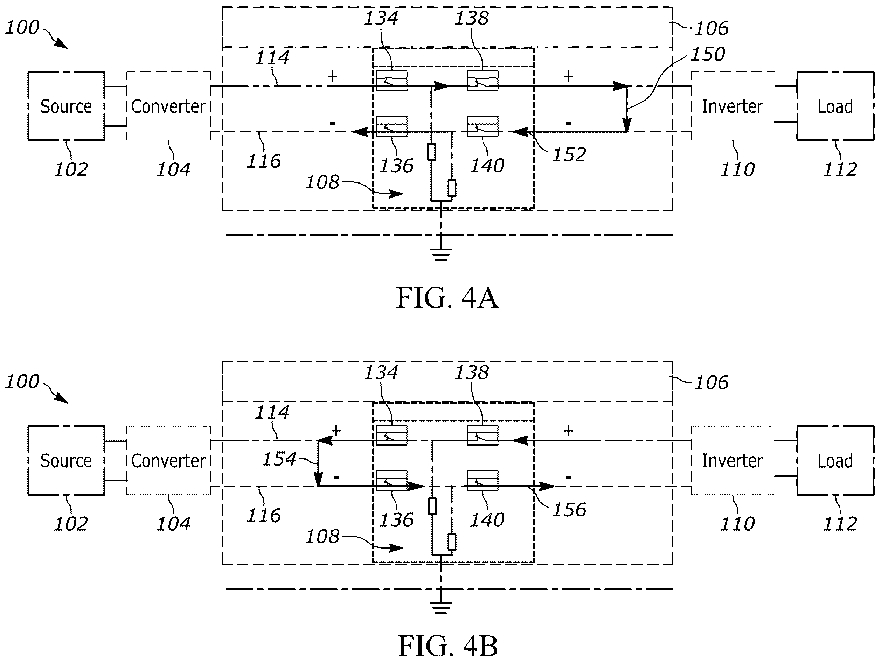

Referring now to FIG. 4A, one example of the circuit of FIG. 1 in the case of a line-to-line fault downstream the high impedance grounding circuit 108 is provided. The circuit of FIG. 4A has the same elements as the circuit of FIG. 1 and these descriptions will not be repeated here.

As shown in FIG. 4A, a Line-to line fault 150 has occurred. In this case, a fault current 152 will flow from the electrical source 102 to the electrical load 112 through the positive power line 114 and then return via the negative power line 116 to the electrical source. As a result, the controller 128 as shown in FIG. 3 actuated the third protection device 138 and the fourth protection device 140. Actuation may have occurred because the current (i.e., the fault current 152) sensed by the current sensor exceeded a predetermined threshold. The third protection device 138 and the fourth protection device 140 were actuated due to a determined direction of the fault current 152. The grounding paths are out of the fault current path but may experience a voltage and current drop. In some forms, the controller 128 may actuate the third protection device 138 to stop the fault current.

Referring now to FIG. 4B, one example of the circuit of FIG. 1 in the case of a line-to-line fault upstream the high impedance grounding circuit 108 is provided. The circuit of FIG. 4B has the same elements as the circuit of FIG. 1 and these descriptions will not be repeated here.

As shown in FIG. 4B, a line-to-line fault 154 has occurred. In this case, a fault current 156 will flow from the electrical load 112 to the electrical source 102 through the positive power line and return via the negative power line to the electrical load. As a result, the controller 128 actuated the first protection device 134 and the second protection device 136. Actuation may have occurred because the current (i.e., the fault current 156) sensed by the current sensor exceeded a predetermined threshold. The first protection device 134 and the second protection device 136 were actuated due to a determined direction of the fault current 156. The grounding paths are out of the fault current path but may experience a voltage and current drop. In some forms, the controller 128 may actuate the first protection device 134 to stop the fault current.

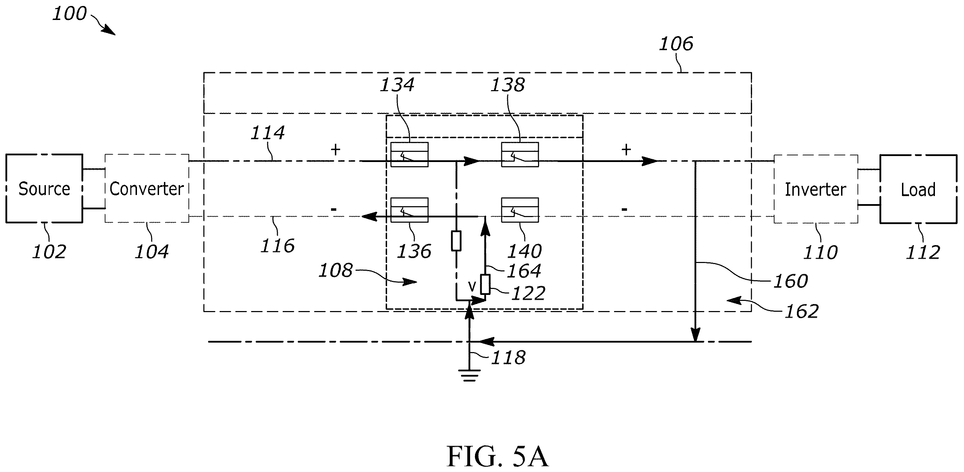

Referring now to FIG. 5A, one example of the circuit of FIG. 1 in the case of a line-to-ground fault downstream the high impedance grounding circuit 108 is provided. The circuit of FIG. 5A has the same elements as the circuit of FIG. 1 and these descriptions will not be repeated here.

As shown in FIG. 5A, a line-to-ground fault 160 occurred. In this case, a fault zone 162 comprises the first protection device 134, the second protection device 136, the electrical ground 118, and the second high impedance grounding path 122. The fault current 164 flows through the second high impedance grounding path 122 connected between the negative power line 116 and the electrical ground 118. As a result, the controller 128 actuated the third protection device 138 and the fourth protection device 140 to isolate the fault zone 162. Actuation may have occurred due to a change in the grounding impedances of the first or second high impedance grounding path 120, 122 or a variation of voltages between the positive pole (i.e., the positive power line 114) to electrical ground 118 and the negative pole (i.e., the negative power line 116) to electrical ground 118. After the actuation, once the fault zone 162 has been isolated, the DC voltage recovers and the electrical power flows over the reconfigured grid at a newly established balance operating point.

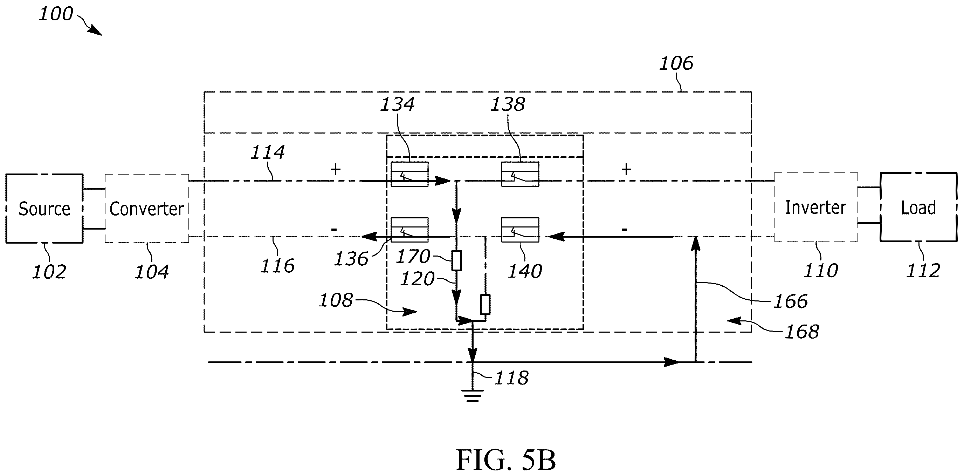

Referring now to FIG. 5B, one example of the circuit of FIG. 1 in the case of a line-to-ground fault downstream the high impedance grounding circuit 108 is provided. The circuit of FIG. 5B has the same elements as the circuit of FIG. 1 and these descriptions will not be repeated here.

As shown in FIG. 5B, a line-to-ground fault 166 has occurred. In this case, a fault zone 168 comprises the first protection device 134, second protection device 136, the electrical ground 118, and the second high impedance grounding path 122. The fault current 170 flows through the first high impedance grounding path 120 connected between the positive power line 114 and the electrical ground 118. As a result, the controller 128 actuated the third protection device 138 and the fourth protection device 140 to isolate the fault zone 168. Actuation may have occurred due to a change in the grounding impedances of the first or second high impedance grounding path 120, 122 or a variation of voltages between the positive pole (i.e., the positive power line 114) to electrical ground 118 and the negative pole (i.e., the negative power line 116) to electrical ground 118. After the actuation, once the fault zone 168 has been isolated, the DC voltage recovers and the electrical power flows over the reconfigured grid at a newly established balance operating point.

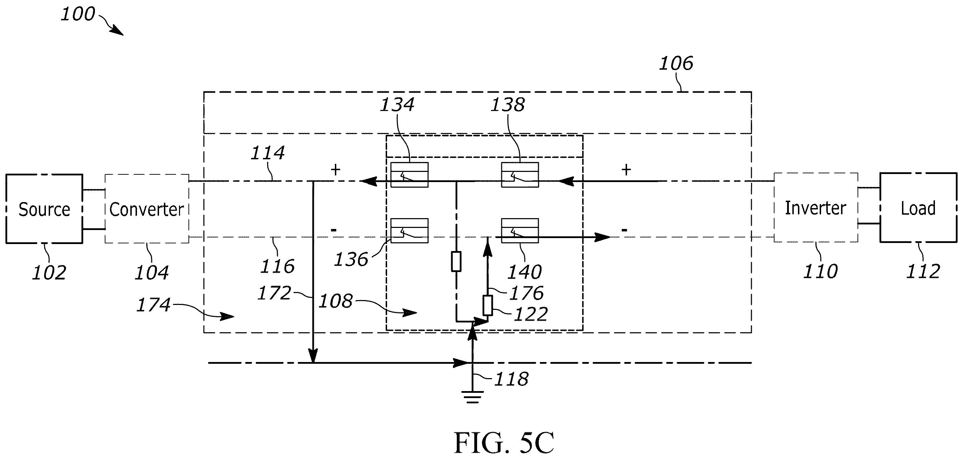

Referring now to FIG. 5C, one example of the circuit of FIG. 1 in the case of a line-to-ground fault upstream the high impedance grounding circuit 108 is provided. The circuit of FIG. 5C has the same elements as the circuit of FIG. 1 and these descriptions will not be repeated here.

As shown in FIG. 5C, a line-to-ground fault 172 has occurred. In this case, a fault zone 174 comprises the third protection device 138, the fourth protection device 140, the electrical ground 118, and the second high impedance grounding path 122. The fault current 176 flows through the second high impedance grounding path 122 connected between the negative power line 116 and electrical ground 118. As a result, the controller 128 actuated the first protection device 134 and the second protection device 136 to isolate the fault zone 174. Actuation may have occurred due to a change in the grounding impedances of the first or second high impedance grounding path 120, 122 or a variation of voltages between the positive pole (i.e., the positive power line 114) to electrical ground 118 and the negative pole (i.e., the negative power line 116) to electrical ground 118. After the actuation, once the fault zone 174 has been isolated, the DC voltage recovers and the electrical power flows over the reconfigured grid at a newly established balance operating point.

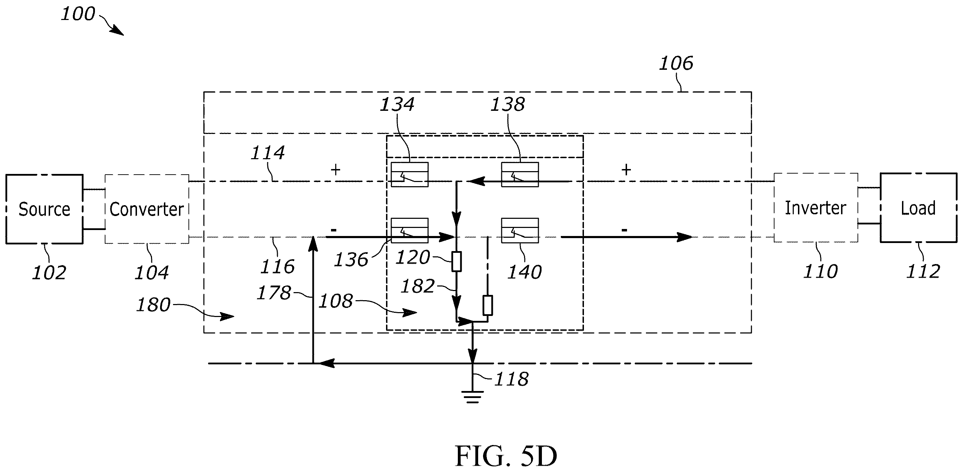

Referring now to FIG. 5D, one example of the circuit of FIG. 1 in the case of a line-to-ground fault upstream the high impedance grounding circuit 108 is provided. The circuit of FIG. 5D has the same elements as the circuit of FIG. 1 and these descriptions will not be repeated here.

As shown in FIG. 5D, a line-to-ground fault 178 has occurred. In this case, a fault zone 180 comprises the third protection device 138, the fourth protection device 140, the electrical ground 118, and the first high impedance grounding path 120. The fault current 182 flows through the first high impedance grounding path 120 connected between the negative power line 116 and electrical ground 118. As a result, the controller 128 actuated the first protection device 134 and the second protection device 136 to isolate the fault zone 180. Actuation may have occurred due to a change in the grounding impedances of the first or second high impedance grounding path 120, 122 or a variation of voltages between the positive pole (i.e., the positive power line 114) to electrical ground 118 and the negative pole (i.e., the negative power line 116) to electrical ground 118. After the actuation, once the fault zone 180 has been isolated, the DC voltage recovers and the electrical power flows over the reconfigured grid at a newly established balance operating point.

It should be appreciated that although the first protection device 134 and the second protection device 136 or the third protection device 138 and the fourth protection device 140 were actuated in the embodiments of FIG. 5A-5D, respectfully, the controller 128 may actuate any combination of the protection devices based on electrical source and electrical load priorities. In this manner, the protection devices 134-140 in electrical connection with the electrical source and loads with lower priorities will be actuated first. After actuation, if the fault zone has not been isolated, the other protection devices 134-140 will be actuated.

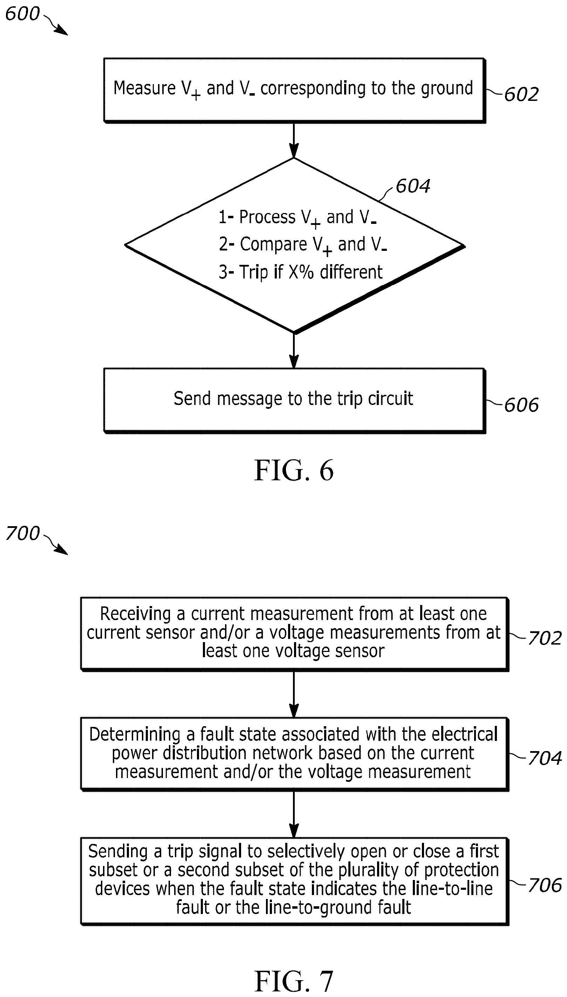

Referring to FIG. 6, a process 600 of detecting a ground fault in accordance with some embodiments is provided. The process 600 may be utilized by the fault detection circuit 126 and the controller 128 with reference to FIG. 1 and 2.

At block 602, a first voltage signal (V₊) between the positive pole (i.e., the positive power line 114) to electrical ground and a second voltage signal (V₋) between the negative pole (i.e., the negative power line 116) to electrical ground are measured. It is generally contemplated that the first voltage signal (V₊) and the second voltage signal (V₋) are measured with a voltage sensor, which is operatively coupled to a controller.

At block 604, the first voltage signal (V₊) and the second voltage signal (V₋) are processed to segregate the noise and transient effects and then compared to determine a degree of symmetry between the two signals V₊, V₋. A predetermined action is triggered by the controller if a difference between the two signals V₊, V₋ exceeds a predetermined threshold. This measurement may indicate the presence of a line-to-ground fault. It is generally contemplated that the first voltage signal (V₊) and the second voltage signal (V₋) are substantially equal with respect to the electrical ground when no line-to-ground faults are detected.

At block 606, a trip signal is transmitted to selectively open one or more of the plurality of protection devices when the difference between the two signals V₊, V₋ exceeds the predetermined threshold.

Referring to FIG. 7, a method 700 of responding to faults in an electrical power distribution network of an aircraft in accordance with some embodiments is provided. The method 700 may be utilized with the electrical power system architecture 100 described above with reference to FIG. 1 and includes a power distribution system grounded through a high impedance grounding circuit, and a plurality of protection devices

At block 702, a current measurement and a voltage measurement are received. In some forms, the current measurement is received from at least one current sensor and the voltage measurement is received from at least one voltage sensor. The voltage measurement includes a first voltage signal (V₊) between the positive pole (i.e., the positive power line) to electrical ground and a second voltage signal (V₋) between the negative pole (i.e., the negative power line) to electrical ground. It is generally contemplated that the current is measured from the at least one current sensor and the voltage is measured from the at least one voltage sensor, which are both operatively coupled to a controller. In some forms, the current sensor may be integrated in the controller.

At block 704, a fault state associated with the electrical power distribution network is determined based on the current measurement and/or the voltage measurement. The current measurement and/or the voltage measurement may indicate no fault, a line-to-line fault, or a line-to-ground fault. The controller is configured to determine the line-to-line fault based on a comparison between the current measurement and a predetermined threshold and configured to determine the line-to-ground fault based on a difference between the first voltage signal (V₊) and the second voltage signal (V₋) exceeding a predetermined threshold. In some forms, the controller is configured to determine the line-to-ground fault based on changing grounding impedances of the high impedance grounding circuit.

At block 706, a trip signal is transmitted to selectively open or close a subset of the plurality of protection devices when the fault state indicates the line-to-line fault or the line-to-ground fault. In some embodiments, the trip signal is transmitted to a subset of the plurality of protection devices based on a detected fault zone. In other embodiments, the trip signal is transmitted to a subset of the plurality of protection devices based on a predetermined order of priority. In some forms, the predetermined order of priority may include electrical source and electrical load priority. The trip signal may be transmitted to a subset of the plurality of protection devices in electrical communication with the electrical source or the electrical load with a lower priority.

In some embodiments, after the trip signal is transmitted, a second fault state associated with the electrical power distribution network is determined. If the fault state (i.e., the line-to-line or line-to-ground) was not removed, a second trip signal is transmitted to selectively open or close a second subset of the plurality of protection devices different from the first subset of the plurality of protection devices. Further, it is generally contemplated that the process 900 may also include the additional operations and actions described above in reference to FIGS. 1 through 6.

Further aspects of the disclosure are provided by the subject matter of the following clauses:

An electrical power system architecture for an aircraft, the electrical power system architecture comprising: at least one electrical source; at least one electrical load; a power distribution system electrically coupling the at least one electrical source to the at least one electrical load, the power distribution system including positive power lines and negative power lines; a high impedance grounding circuit connected between the power distribution system and an electrical ground of the aircraft; a plurality of protection devices coupled to the power distribution system, wherein a first subset of the plurality of protection devices are coupled electrically upstream of the high impedance grounding circuit and a second subset of the plurality of protection devices are coupled electrically downstream of the high impedance grounding circuit; a fault detection circuit configured to detect a fault; and a controller communicatively coupled to the high impedance grounding circuit, the plurality of protection devices, and the fault detection circuit, the controller configured to selectively open or close the first subset and/or the second subset of the plurality of protection devices based on the detected fault.

The electrical power system architecture of any preceding clause, wherein the power distribution system further comprises a power distribution box including a power input coupled to the at least one electrical source and a power output coupled to the at least one electrical load, and wherein the high impedance grounding circuit, the plurality of protection devices, and the fault detection circuit are enclosed in the power distribution box.

The electrical power system architecture of any preceding clause, wherein the high impedance grounding circuit includes a first high impedance grounding path connected between the positive lines and the electrical ground and a second high impedance grounding path connected between the negative lines and the electrical ground, and wherein the first and second high impedance grounding path comprises a first resistor electrically in parallel with damper circuit.

The electrical power system architecture of any preceding clause, wherein the high impedance grounding circuit includes a first high impedance grounding path connected between the positive lines and the electrical ground and a second high impedance grounding path connected between the negative lines and the electrical ground, wherein the first and second high impedance grounding path comprise a resistor.

The electrical power system architecture of any preceding clause, wherein the first subset of the plurality of protection devices includes at least one protection device coupled to a positive line of the power distribution system and at least one protection device coupled to a negative line of the power distribution system electrically upstream of the high impedance grounding circuit; and wherein the second subset of the plurality of protection devices includes at least one protection device coupled to the positive line of the power distribution system and at least one protection device the negative line of the power distribution system electrically downstream of the high impedance grounding circuit.

The electrical power system architecture of any preceding clause, wherein the first subset and the second subset of the plurality of protection devices include at least one fast-acting protection device.

The electrical power system architecture of any preceding clause, wherein the fault detection circuit comprises an impedance monitor or a voltage detector.

The electrical power system architecture of any preceding clause, further comprising an electrical wiring interconnection system configured to separate a positive line and a negative line of the power distribution system.

The electrical power system architecture of any preceding clause, wherein the controller is configured to selectively open the first subset or the second subset of the plurality of protection devices based on a fault zone.

The electrical power system architecture of any preceding clause, wherein the controller is configured to selectively open the first subset or the second subset of the plurality of protection devices based on a predetermined priority order.

The electrical power system architecture of any preceding clause, wherein the at least one electrical source includes at least one of a battery, a fuel cell or a generator; and wherein the at least one electrical load includes at least one of a pump, a motor, a heating element, or electrical distribution equipment.

A protection system for an electrical power distribution network of an aircraft, the electrical power distribution network including one or more electrical sources connected to one or more electrical loads through a power distribution system, the power distribution system connected to an electrical ground of the aircraft by a high impedance grounding circuit, the protection system comprising: an electrical wiring interconnection system separating positive power lines and negative power lines of the power distribution system for reducing line-to-line faults; a plurality of protection devices coupled to the power distribution system, wherein a first subset of the plurality of protection devices are coupled electrically upstream of the high impedance grounding circuit and a second subset of the plurality of protection devices are coupled electrically downstream of the high impedance grounding circuit; a ground fault detector operably connected to the high impedance grounding circuit and to the electrical ground; and a controller coupled to the power distribution system, the high impedance grounding circuit, the plurality of protection devices, the ground fault detector, and at least one current sensor, the controller configured to: receive input from the at least one current sensor and/or the ground fault detector; determine a fault state associated with the electrical power distribution network based on the received input, the fault state comprising no faults, a line-to-line fault or a line-to-ground fault; and send a trip signal to selectively open or close the first subset or the second subset of the plurality of protection devices when the fault state indicates the line-to-line fault or the line-to-ground fault.

The protection system of any preceding clause, wherein the ground fault detector comprises a voltage sensor configured to measure a first voltage value between the positive power lines and the electrical ground and a second voltage value between the negative power lines and the electrical ground.

The protection system of any preceding clause, wherein the controller is configured to: receive the input including the measured first voltage value and the second voltage value and determine a line-to-ground fault based on a difference between the measured first voltage value and the second voltage value, and send the trip signal to selectively open the first subset or the second subset of the plurality of protection devices when the difference between the first voltage value and the second voltage value exceeds a predetermined threshold.

The protection system of any preceding clause, wherein the controller is configured further configured to: send the trip signal to selectively open or close either the first subset or the second subset of the plurality of protection devices, determine if the line-to-ground fault is removed; and send a trip signal to selectively open or close the other one of the first subset or the second subset of the plurality of protection devices when the line-to-ground fault is not removed.

The protection system of any preceding clause, wherein the controller is configured to: receive the input including a current measurement from the at least one current sensor and determine a line-to-line fault based on a comparison between the current measurement and a predetermined threshold; and send the trip signal to selectively open the first subset and/or the second subset of the plurality of protection devices when the current measurement exceeds a predetermined threshold.

The protection system of any preceding clause, wherein the controller is further configured to send the trip signal to selectively open or close the first subset or the second subset of the plurality of protection devices based on a predetermined order of priority.

The protection system of any preceding clause, wherein the controller is further configured to send the trip signal to selectively open or close the first subset or the second subset of the plurality of protection devices based on a predetermined command.

The protection system of any preceding clause, wherein the first subset and the second subset of the plurality of protection devices include at least one fast-acting protection device and at least one slow-acting protection device.

A method of responding to faults in an electrical power distribution network of an aircraft, the electrical power distribution network including a power distribution system grounded through a high impedance grounding circuit, and a plurality of protection devices, the method comprising: receiving a current measurement from at least one current sensor and/or a voltage measurements from at least one voltage sensor, wherein the voltage measurement includes a first voltage value between a positive line and electrical ground and a second voltage value between a negative line and ground; determining a fault state associated with the electrical power distribution network based on the current measurement and/or the voltage measurement, the fault state comprising no faults, a line-to-line fault, or a line-to-ground fault; and sending a trip signal to selectively open or close a first subset or a second subset of the plurality of protection devices when the fault state indicates the line-to-line fault or the line-to-ground fault; wherein the fault state indicates a line-to-line fault when the current measurement exceeds a predetermined threshold; and wherein the fault state indicates a line-to-ground fault when a difference between the first voltage value and the second voltage value of the voltage measurement exceeds a predetermined threshold.

## Claims

1. An electrical power system architecture (100) for an aircraft, the electrical power system architecture (100) comprising:
at least one electrical source (102);
at least one electrical load (112);
a power distribution system (106) electrically coupling the at least one electrical source (102) to the at least one electrical load (112), the power distribution system (106) including positive power lines (114) and negative power lines (116);
a high impedance grounding circuit (108) connected between the power distribution system (106) and an electrical ground (118) of the aircraft;
a plurality of protection devices (124) coupled to the power distribution system (106), wherein a first subset (134) (136) of the plurality of protection devices (124) are coupled electrically upstream of the high impedance grounding circuit (108) and a second subset (138)(140) of the plurality of protection devices (124) are coupled electrically downstream of the high impedance grounding circuit (108);
a fault detection circuit (126) configured to detect a fault; and
a controller (128) communicatively coupled to the high impedance grounding circuit (108), the plurality of protection devices (124), and the fault detection circuit (126), the controller (128)configured to selectively open or close the first subset (134) (136) and/or the second subset (138)(140) of the plurality of protection devices (124) based on the detected fault.

2. The electrical power system architecture (100) of claim 1, wherein the power distribution system (106) further comprises a power distribution box including a power input coupled to the at least one electrical source (102) and a power output coupled to the at least one electrical load (112), and wherein the high impedance grounding circuit (108), the plurality of protection devices (124), and the fault detection circuit (126) are enclosed in the power distribution box.

3. The electrical power system architecture (100) of claim 1 or 2, wherein the high impedance grounding circuit (108) includes a first high impedance grounding path (120) connected between the positive power lines (114) and the electrical ground (118) and a second high impedance grounding path (122) connected between the negative power lines (116) and the electrical ground (118), and wherein the first and second high impedance grounding path (120) (122) comprises a first resistor (202) electrically in parallel with damper circuit (204).

4. The electrical power system architecture (100) of claim 1 or 2, wherein the high impedance grounding circuit (108) includes a first high impedance grounding path (120) connected between the positive power lines (114) and the electrical ground (118) and a second high impedance grounding path (122) connected between the negative power lines (116) and the electrical ground (118), wherein the first and second high impedance grounding path (122) comprise a resistor (130)(132).

5. The electrical power system architecture (100) of any of claims 1 to 4,
wherein the first subset of the plurality of protection devices (124) includes at least one protection device (134) coupled to a positive power line (114) of the power distribution system (106) and at least one protection device (136) coupled to a negative power line (116) of the power distribution system (106) electrically upstream of the high impedance grounding circuit (108); and
wherein the second subset of the plurality of protection devices (124) includes at least one protection device (138) coupled to the positive power line (114) of the power distribution system (106) and at least one protection device (140) the negative power line (116) of the power distribution system (106) electrically downstream of the high impedance grounding circuit (108).

6. The electrical power system architecture (100) of any of claims 1 to 5, wherein the fault detection circuit (126) comprises an impedance monitor or a voltage detector.

7. The electrical power system architecture (100) of any of claims 1 to 6, further comprising an electrical wiring interconnection system configured to separate a positive power line (114) and a negative power line (116) of the power distribution system (106).

8. The electrical power system architecture (100) of any of claims 1 to 7, wherein the controller (128) is configured to selectively open the first subset (134)(136) or the second subset (138)(140) of the plurality of protection devices (124) based on a predetermined priority order.

9. The electrical power system architecture (100) of any of claims 1 to 8,
wherein the at least one electrical source (102) includes at least one of a battery, a fuel cell or a generator; and
wherein the at least one electrical load (112) includes at least one of a pump, a motor, a heating element, or electrical distribution equipment.

10. The electrical power system architecture (100) of any of claims 1 to 9, wherein the first subset (134)(136) and the second subset (138)(140) of the plurality of protection devices (124) include at least one fast-acting protection device.

11. The electrical power system architecture (100) of any of claims 1 to 10, wherein the fault detection circuit (126) comprises a voltage sensor configured to measure a first voltage value between the positive power line (114) and the electrical ground (118) and a second voltage value between the negative power line (116) and the electrical ground (118).

12. The electrical power system architecture (100) of claim 11, wherein the controller (128) is configured to:
receive input including the measured first voltage value and the second voltage value and determine a line-to-ground fault based on a difference between the measured first voltage value and the second voltage value, and
send the trip signal to selectively open the first subset (134)(136) or the second subset (138)(140) of the plurality of protection devices (124) when the difference between the first voltage value and the second voltage value exceeds a predetermined threshold.

13. The electrical power system architecture (100) of claim 12, wherein the controller (128) is configured further configured to:
send the trip signal to selectively open or close either the first subset (134)(136) or the second subset (138)(140) of the plurality of protection devices (124),
determine if the line-to-ground fault is removed; and
send a trip signal to selectively open or close the other one of the first subset (134)(136) or the second subset (138)(140) of the plurality of protection devices (124) when the line-to-ground fault is not removed.

14. The electrical power system architecture (100) of any of claims 1 to 13, wherein the controller (128) is configured to:
receive input including a current measurement from at least one current sensor and determine a line-to-line fault based on a comparison between the current measurement and a predetermined threshold; and
send the trip signal to selectively open the first subset (134)(136) and/or the second subset (138)(140) of the plurality of protection devices (124) when the current measurement exceeds a predetermined threshold.

15. The electrical power system architecture (100) of any of claims 1 to 14, wherein the controller (128) is further configured to send the trip signal to selectively open or close the first subset (134)(136) or the second subset (138)(140) of the plurality of protection devices (124) based on a predetermined order of priority.
